# EUROPÄISCHE PATENTANMELDUNG

(11) **EP 3 954 801 A1**
(43) Veröffentlichungstag der Anmeldung: **16.02.2022**
(21) Anmeldenummer: 20190256.6
(22) Anmeldetag: 10.08.2020
(51) Int. Cl.: C23C 4/08, B21C 37/09, C23C 4/134, C23C 4/137, C23C 4/16, C23C 4/18, C23C 14/16, C23C 16/06

(54) **VERFAHREN ZUR ERZEUGUNG VON MEHRWANDIGEN ROHREN UND MEHRWANDIGES ROHR**

(71) Anmelder: TI Automotive Engineering Centre (Heidelberg) GmbH, 69123 Heidelberg (DE)
(72) Erfinder: Stahn, Andreas, 69231 Rauenberg (DE); Weick, Georg, 68723 Plankstadt (DE)
(74) Vertreter: Andrejewski - Honke Patent- und Rechtsanwälte Partnerschaft mbB

(57) **Zusammenfassung**

Verfahren zur Erzeugung von mehrwandigen Rohren, wobei ein Metallband zu dem mehrwandigen Rohr aufgerollt wird. Das Metallband weist zumindest eine Stahlschicht auf und auf die Stahlschicht ist zumindest eine Lotschicht aufgebracht. Die Lotschicht besteht zumindest teilweise aus Metall. Erfindungsgemäß wird die Lotschicht durch Plasmabeschichtung auf die Stahlschicht aufgebracht.

## Beschreibung

Die Erfindung betrifft ein Verfahren zur Erzeugung von mehrwandigen Rohren, wobei ein Metallband zu dem mehrwandigen Rohr aufgerollt wird, wobei das Metallband zumindest eine Stahlschicht aufweist und wobei auf die Stahlschicht zumindest eine Lotschicht aufgebracht wird und wobei die Lotschicht zumindest teilweise aus Metall besteht und vorzugsweise zumindest im Wesentlichen aus Metall besteht. - Zur Erzeugung des Metallbandes wird von einem die Stahlschicht bildenden Stahlband ausgegangen, das die entsprechende Beschichtung erfährt und anschließend zu dem mehrwandigen Rohr aufgerollt wird. - Die Erfindung betrifft fernerhin ein mehrwandiges Rohr mit einem solchen aufgerollten Metallband.

Verfahren der vorstehend beschriebenen Art sind aus der Praxis grundsätzlich bekannt. Dabei wird die Abscheidung der Lotschicht mit Hilfe eines galvanotechnischen Verfahrens realisiert. Eine ausreichende Haftung ist hier aber in der Regel nur mit cyanidhaltigen Elektrolytbädern erzielbar. Es versteht sich, dass der Einsatz von hochgiftigen Cyaniden mit beachtlichen Nachteilen verbunden ist. Im Übrigen ist das galvanische Verfahren aufwendig und kostspielig und es sind komplexe bzw. aufwendige Einstellungen der Verfahrensparameter erforderlich. Auch die einzelnen Verfahrensschritte (Ansetzen des Elektrolytbades, Trocknen, Säubern usw.) sind zeitaufwendig. Weiterhin ist die Entsorgung von verbleibenden Reststoffen problematisch. Im Rahmen der bekannten Maßnahmen muss zur Aufbringung einer Kupferschicht als Lotschicht in aufwendiger Weise eine Nickelschicht zwischen Stahlschicht und Kupferschicht zwischengeschaltet werden. Hinzu kommt, dass Nickel als gesundheitsschädlich eingestuft wird. Insoweit besteht Verbesserungsbedarf.

Demgegenüber liegt der Erfindung das technische Problem zugrunde, ein Verfahren der eingangs beschriebenen Art anzugeben, das auf einfache, kostengünstige und wenig aufwendige Weise die Beschichtung des Metallbandes bzw. Stahlbandes mit einer Lotschicht erlaubt und das außerdem in umwelttechnischer und gesundheitlicher Hinsicht weniger Nachteile aufweist. Der Erfindung liegt weiterhin das technische Problem zugrunde, ein entsprechendes mehrwandiges Rohr anzugeben.

Zur Lösung dieses technischen Problems lehrt die Erfindung zunächst ein Verfahren zur Erzeugung von mehrwandigen Rohren, wobei ein Metallband zu dem mehrwandigen Rohr aufgerollt wird, wobei das Metallband zumindest eine Stahlschicht aufweist, wobei auf die Stahlschicht zumindest eine Lotschicht aufgebracht wird, wobei die Lotschicht zumindest teilweise aus Metall besteht und vorzugsweise zumindest im Wesentlichen aus Metall besteht und wobei die Lotschicht durch Plasmabeschichtung auf die Stahlschicht aufgebracht wird.

Als Ausgangsband bzw. Ausgangsschicht zur Erzeugung des erfindungsgemäßen Metallbandes wird somit ein Stahlband bzw. eine Stahlschicht eingesetzt, die mit der weiteren Beschichtung versehen wird. - Vor Aufbringung der Lotschicht wird das Stahlband bzw. die Stahlschichten zweckmäßigerweise gereinigt. Eine bevorzugte Ausführungsform, der im Rahmen der Erfindung besondere Bedeutung zukommt, ist dadurch gekennzeichnet, dass die Reinigung der zu beschichtenden Oberfläche des Stahlbandes bzw. der Stahlschicht mittels Plasmabehandlung gereinigt wird. Zweckmäßigerweise erfolgt diese Reinigung mit der weiter unten noch beschriebenen vorzugsweise eingesetzten Plasmabeschichtungs-Vorrichtung. Dabei wird vorzugsweise die zu reinigende Oberfläche des Stahlbandes bzw. der Stahlschicht mit einem Plasmastrahl bzw. mit einer Plasmaflamme beaufschlagt. Diese Reinigungsmethode hat sich im Rahmen der Erfindung besonders bewährt.

Eine sehr empfohlene Ausführungsform der Erfindung ist dadurch gekennzeichnet, dass die Lotschicht zumindest teilweise aus Kupfer besteht. Vorzugsweise besteht die Lotschicht vollständig aus Kupfer bzw. im Wesentlichen aus Kupfer. Grundsätzlich können auch andere Metalle für die Lotschicht eingesetzt werden.

Besondere Bedeutung kommt im Rahmen der Erfindung der erfindungsgemäßen Ausgestaltung zu, wonach die Lotschicht - insbesondere die Kupferschicht - ohne Zwischenschaltung einer weiteren Metallschicht - insbesondere ohne Zwischenschaltung einer Nickelschicht - auf die Stahlschicht bzw. auf das Stahlband aufgebracht wird. Der Erfindung liegt insoweit die Erkenntnis zugrunde, dass aufgrund der erfindungsgemäßen Plasmabeschichtung problemlos auf eine Nickelschicht verzichtet werden kann und nichtsdestoweniger eine ausreichende Haftung der Lotschicht erzielt werden kann. Dies hat den Vorteil, dass auch die mit der Nickelschicht verbundenen umwelttechnischen Nachteile vermieden werden können.

Es liegt im Rahmen der Erfindung, dass die Stahlschicht bzw. das Stahlband eine Dicke von 100 bis 600 µm, insbesondere von 200 bis 400 µm aufweist. - Nach besonders empfohlener Ausführungsform der Erfindung wird die Lotschicht - insbesondere die Kupferschicht - mit einer Dicke von 1 bis 50 µm, vorzugsweise von 2 bis 20 µm und insbesondere von 3 bis 10 µm durch Plasmabeschichtung auf die Stahlschicht bzw. auf das Stahlband aufgebracht. - Zweckmäßigerweise ist die Stahlschicht dicker als die Lotschicht und insbesondere mindestens fünfmal, vorzugsweise mindestens siebenmal und bevorzugt mindestens zehnmal so dick wie die Lotschicht.

Es liegt im Rahmen der Erfindung, dass die Beschichtung bzw. die Beschichtung mit der Lotschicht ohne Einsatz von Cyaniden erfolgt und es liegt fernerhin im Rahmen der Erfindung, dass die Beschichtung bzw. die Beschichtung mit der Lotschicht ohne Einsatz von Nickel erfolgt. Der Erfindung liegt insoweit die Erkenntnis zugrunde, dass bei Durchführung der erfindungsgemäßen Plasmabeschichtung auf die nachteilhaften cyanidhaltigen Elektrolytbäder vollständig verzichtet werden kann. Der Erfindung liegt weiterhin die Erkenntnis zugrunde, dass auch eine zwischengeschaltete Nickelschicht zwischen der Stahlschicht und der Lotschicht bzw. zwischen der Stahlschicht und der Kupferschicht nicht erforderlich ist. Von daher zeichnet sich die Erfindung im Hinblick auf Gesundheitsaspekte und im Hinblick auf Umweltaspekte durch beachtliche Vorteile aus.

Eine besonders bevorzugte Ausführungsform des erfindungsgemäßen Verfahrens ist dadurch gekennzeichnet, dass die Plasmabeschichtung bei Normaldruck bzw. Atmosphärendruck durchgeführt wird. Diese Ausführungsform zeichnet sich durch Einfachheit und geringen Aufwand aus. Nichtsdestoweniger könnte die Plasmabeschichtung auch unter anderen Druckverhältnissen, beispielsweise im Vakuum durchgeführt werden.

Es liegt im Rahmen der Erfindung, dass die Plasmabeschichtung als physikalische Gasphasenabscheidung und/oder als chemische Gasphasenabscheidung durchgeführt wird. - Zweckmäßigerweise wird eine Plasmabeschichtungs-Vorrichtung zur Aufbringung der Plasmabeschichtung eingesetzt. Es liegt dabei im Rahmen der Erfindung, dass das Material für die Lotschicht - insbesondere das Kupfermaterial für die Lotschicht - in der Plasmabeschichtungs-Vorrichtung pulverförmig zugeführt wird. Zweckmäßigerweise wird das Material für die Lotschicht - insbesondere das Kupfermaterial für die Lotschicht - in der Plasmabeschichtungs-Vorrichtung in die Gasphase überführt und anschließend auf der Stahlschicht als Lotschicht bzw. als Kupferschicht abgeschieden. Der Erfindung liegt die Erkenntnis zugrunde, dass diese Plasmabeschichtung der Lotschicht überraschend einfach und wenig aufwendig erfolgen kann und dass vor allem eine optimale Haftung der Lotschicht bzw. der Kupferschicht an der Stahlschicht erzielt werden kann ohne dass eine zwischengeschaltete Nickelschicht erforderlich ist.

Nach besonders bevorzugter Ausführungsform der Erfindung wird das Metallband aus zumindest der Stahlschicht bzw. dem Stahlband und der darauf aufgebrachten Lotschicht zu einem doppelwandigen Rohr aufgerollt. Grundsätzlich sind auch Rohre mit mehr als zwei Wänden möglich und durch entsprechendes Aufrollen können derartige Rohre erzeugt werden. Ein doppelwandiges Rohr wird im Rahmen der Erfindung aber besonders bevorzugt.

Nach einer empfohlenen Ausführungsform wird die Stahlschicht bzw. das Stahlband auf beiden Oberflächen mit der Lotschicht - insbesondere mit der Kupferschicht - beschichtet. Vorzugsweise werden dabei beide Oberflächen der Stahlschicht bzw. des Stahlbandes mittels Plasmabeschichtung mit der Lotschicht beschichtet.

Es liegt im Rahmen der Erfindung, dass die Wandschichten des mehrwandigen Rohres - insbesondere des doppelwandigen Rohres - durch Erhitzen miteinander verlötet bzw. miteinander verbunden werden. Nach einer empfohlenen Ausführungsform wird das Metallband mit Hilfe von Walzen aufgerollt bzw. zusammengerollt. Weiterhin ist es im Rahmen der Erfindung bevorzugt, dass das Rohr anschließend mittels eines Induktionsofens erhitzt wird, wodurch die Lotschicht schmilzt. Auf diese Weise können die Wände des Rohres miteinander verlötet werden und das Rohr entsprechend abgedichtet werden. Gegenstand der Erfindung ist auch ein mehrwandiges Rohr mit einem aufgerollten Metallband, wobei das Metallband zumindest eine Stahlschicht bzw. zumindest ein Stahlband und zumindest eine auf die Stahlschicht bzw. auf das Stahlband mittels Plasmabeschichtung aufgebrachte Lotschicht aufweist. Dabei handelt es sich besonders bevorzugt um ein doppelwandiges Rohr.

Der Erfindung liegt die Erkenntnis zugrunde, dass mit dem erfindungsgemäßen Verfahren eine sehr einfache und wenig aufwendige sowie kostengünstige Erzeugung von mehrwandigen bzw. doppelwandigen Rohren möglich ist. Dabei werden in vorteilhafter Weise keine nasschemischen Verfahrensschritte benötigt und insbesondere keine Verfahrensschritte mit in umwelttechnischer Hinsicht bedenklichen Substanzen. Das erfindungsgemäße Verfahren ist weniger komplex als das aus der Praxis bekannte und eingangs erläuterte Verfahren. Viele zusätzliche und aufwendige Verfahrensschritte - wie beispielsweise Trocknungsschritte, Reinigungsschritte und Entsorgungsschritte für umweltgefährdende Substanzen - können vermieden werden. Auf giftige Substanzen wie Cyanide kann vollständig verzichtet werden und insbesondere ist die aufwendige Zwischenschaltung einer Nickelschicht bei dem erfindungsgemäßen Verfahren nicht erforderlich. Im Vergleich zu dem eingangs beschriebenen bekannten Verfahren wird bei dem erfindungsgemäßen Verfahren insgesamt weniger Material eingesetzt und weniger Energie verbraucht und somit sind auch die Kosten geringer. Neben diesen Aspekten weist die durch Plasmabehandlung aufgebrachte Beschichtung aber auch eine wesentlich bessere Qualität auf als die aus der Praxis bekannten Beschichtungen. Die Lotschicht bzw. Kupferschicht kann mit überraschend hoher Homogenität und mit gezielt eingestellter Dicke aufgebracht werden. Dadurch wird auch das Verlöten der Schichten deutlich verbessert. Insgesamt zeichnet sich die Erfindung durch eine Vielzahl von Vorteilen aus. Ganz besonders herauszustellen sind dabei Einfachheit, geringer Aufwand und geringe Kosten.

Nachfolgend wird die Erfindung anhand einer lediglich ein Ausführungsbeispiel darstellenden Zeichnung näher erläutert. Es zeigen in schematischer Darstellung:
- Fig. 1: eine perspektivische Darstellung eines Metallbandes vor dem Aufrollen zu dem mehrwandigen Rohr,
- Fig. 2: ein aus dem Metallband aufgerolltes doppelwandiges Rohr im Schnitt und
- Fig. 3: eine schematische Darstellung einer zur Durchführung des erfindungsgemäßen Verfahrens vorzugsweise eingesetzten Plasmabeschichtungs-Vorrichtung

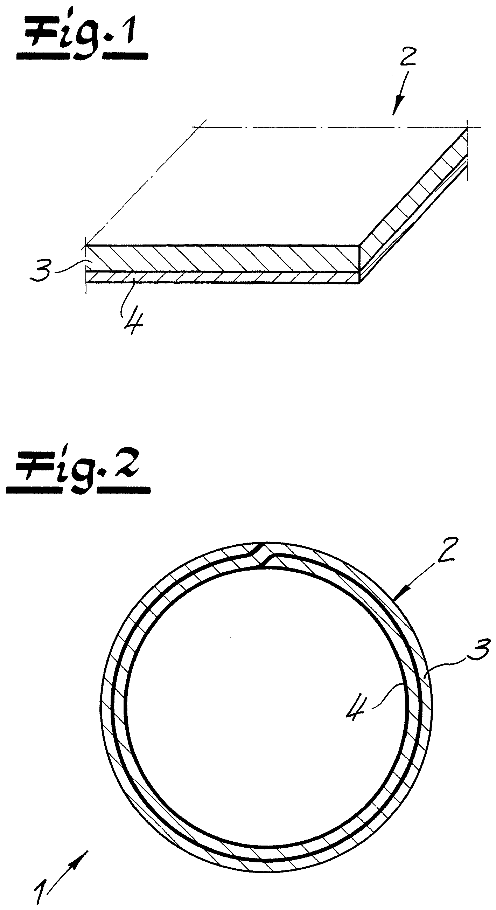

Die Figuren verdeutlichen ein erfindungsgemäßes Verfahren zur Erzeugung von mehrwandigen Rohren 1. Vorzugsweise und im Ausführungsbeispiel (siehe insbesondere Fig. 2) wird mit dem erfindungsgemäßen Verfahren ein doppelwandiges Rohr 1 hergestellt. Dazu wird ein Metallband 2 zu dem doppelwandigen Rohr 1 aufgerollt. Zweckmäßigerweise und im Ausführungsbeispiel weist das Metallband eine Stahlschicht 3 bzw. ein Stahlband auf. Auf diese Stahlschicht 3 wird bevorzugt und im Ausführungsbeispiel eine Lotschicht 4 aus Kupfer aufgebracht.

Im Ausführungsbeispiel mag die Stahlschicht eine Dicke von 200 bis 400 µm aufweisen und die Lotschicht 4 bzw. die Kupferschicht eine Dicke von 3 bis 10 µm aufweisen. Vorzugsweise und im Ausführungsbeispiel ist die Stahlschicht 3 deutlich dicker als die Lotschicht 4 bzw. als die Kupferschicht. Erfindungsgemäß erfolgt die Beschichtung mit der Lotschicht 4 ohne Zwischenschaltung einer Nickelschicht, wie es aus dem Stand der Technik bekannt ist.

Erfindungsgemäß wird die Lotschicht 4 bzw. die Kupferschicht durch Plasmabeschichtung auf die Stahlschicht 3 bzw. auf das Stahlband aufgebracht. Zweckmäßigerweise wird die Plasmabeschichtung bei Normaldruck bzw. Atmosphärendruck durchgeführt. Es liegt im Rahmen der Erfindung, dass die Plasmabeschichtung als physikalische Gasphasenabscheidung erfolgt.

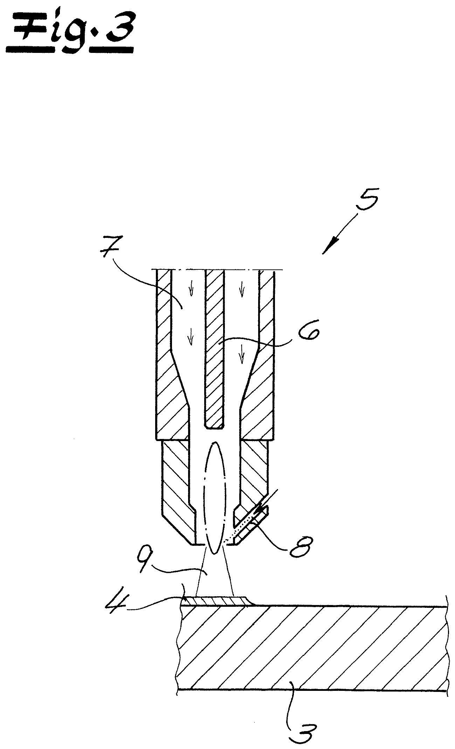

In der Fig. 3 ist eine für das erfindungsgemäße Verfahren geeignete Plasmabeschichtungs-Vorrichtung 5 dargestellt. Die Fig. 3 zeigt die Elektrode 6 dieser Plasmabeschichtungs-Vorrichtung 5 sowie den Gaszuführungsraum 7. Es liegt im Rahmen der Erfindung, dass das Material für die Lotschicht 4 - insbesondere das Kupfermaterial für die Lotschicht 4 - in der Plasmabeschichtungs-Vorrichtung 5 pulverförmig zugeführt wird und zwar zweckmäßigerweise und im Ausführungsbeispiel durch den Kanal 8 pulverförmig zugeführt wird. Vorzugsweise und im Ausführungsbeispiel wird das Material für die Lotschicht 4 - insbesondere das Kupfermaterial für die Lotschicht 4 - in der Plasmabeschichtungs-Vorrichtung 5 in die Gasphase überführt und anschließend auf der Stahlschicht 3 als Lotschicht 4 bzw. als Kupferschicht abgeschieden. In Fig. 3 ist im Übrigen auch der Plasmastrahl 9 erkennbar.

Nach der Abscheidung der Lotschicht 4 erhält man das in Fig. 1 dargestellte beschichtete Metallband 2. Dieses Metallband 2 wird dann vorzugsweise mit Hilfe von Walzen zu dem in Fig. 2 dargestellten doppelwandigen Rohr 1 aufgerollt. Es liegt im Rahmen der Erfindung, dass dann das Rohr 1 bzw. die Wandschichten des Rohres 1 durch Erhitzen miteinander verlötet bzw. miteinander verbunden werden. Zweckmäßigerweise erfolgt diese Erhitzung in einem nicht dargestellten Induktionsofen.

Die erfindungsgemäße Herstellung des mehrwandigen bzw. doppelwandigen Rohres 1 kann in vorteilhafter Weise ohne Einsatz von cyanidhaltigen Elektrolytbädern durchgeführt werden und kann in vorteilhafter Weise auch ohne Zwischenschaltung einer Nickelschicht zwischen Lotschicht 4 und Stahlschicht 3 erfolgen.

## Patentansprüche

1. Verfahren zur Erzeugung von mehrwandigen Rohren (1), wobei ein Metallband (2) zu dem mehrwandigen Rohr (1) aufgerollt wird, wobei das Metallband (2) zumindest eine Stahlschicht (3) aufweist und wobei auf die Stahlschicht (3) zumindest eine Lotschicht (4) aufgebracht wird, wobei die Lotschicht zumindest teilweise aus Metall besteht und vorzugsweise zumindest im Wesentlichen aus Metall besteht, **dadurch gekennzeichnet, dass** die Lotschicht (4) durch Plasmabeschichtung auf die Stahlschicht (3) aufgebracht wird.

2. Verfahren nach Anspruch 1, wobei die Lotschicht (4) zumindest teilweise aus Kupfer besteht und vorzugsweise aus Kupfer besteht bzw. im Wesentlichen aus Kupfer besteht.

3. Verfahren nach einem der Ansprüche 1 oder 2, wobei die Lotschicht (4), insbesondere die Kupferschicht, ohne Zwischenschaltung einer weiteren Metallschicht, insbesondere ohne Zwischenschaltung einer Nickelschicht auf die Stahlschicht (3) aufgebracht wird.

4. Verfahren nach einem der Ansprüche 1 bis 3, wobei die Stahlschicht (3) eine Dicke von 100 bis 600 µm, insbesondere von 200 bis 400 µm aufweist.

5. Verfahren nach einem der Ansprüche 1 bis 4, wobei die Lotschicht (4), insbesondere die Kupferschicht mit einer Dicke von 1 bis 50 µm, vorzugsweise von 2 bis 20 µm, insbesondere von 3 bis 10 µm durch Plasmabeschichtung auf die Stahlschicht (3) aufgebracht wird.

6. Verfahren nach einem der Ansprüche 1 bis 5, wobei die Stahlschicht (3) dicker ist als die Lotschicht (4) und insbesondere mindestens fünfmal, vorzugsweise mindestens siebenmal und bevorzugt mindestens zehnmal so dick ist wie die Lotschicht (4).

7. Verfahren nach einem der Ansprüche 1 bis 6, wobei die Beschichtung ohne Einsatz von Cyaniden und/oder ohne Einsatz von Nickel aufgebracht wird.

8. Verfahren nach einem der Ansprüche 1 bis 7, wobei die Plasmabeschichtung bei Normaldruck bzw. Atmosphärendruck durchgeführt wird.

9. Verfahren nach einem der Ansprüche 1 bis 8, wobei die Plasmabeschichtung als physikalische Gasphasenabscheidung und/oder als chemische Gasphasenabscheidung durchgeführt wird.

10. Verfahren nach einem der Ansprüche 1 bis 9, wobei das Material für die Lotschicht (4) - insbesondere das Kupfermaterial für die Lotschicht (4) - in einer Plasmabeschichtungs-Vorrichtung (5) pulverförmig zugeführt wird.

11. Verfahren nach einem der Ansprüche 1 bis 10, wobei das Material für die Lotschicht (4) - insbesondere das Kupfermaterial für die Lotschicht (4)- in der Plasmabeschichtungs-Vorrichtung (5) in die Gasphase überführt wird und anschließend auf der Stahlschicht (3) als Lotschicht (4) bzw. als Kupferschicht abgeschieden wird.

12. Verfahren nach einem der Ansprüche 1 bis 11, wobei das Metallband aus zumindest der Stahlschicht (3) und der Lotschicht (4) zu einem doppelwandigen Rohr (1) aufgerollt wird.

13. Verfahren nach einem der Ansprüche 1 bis 12, wobei die Stahlschicht (3) auf beiden Oberflächen mit der Lotschicht (4) beschichtet wird und vorzugsweise auf beiden Oberflächen mittels Plasmabeschichtung mit der Lotschicht (4) beschichtet wird.

14. Verfahren nach einem der Ansprüche 1 bis 13, wobei die Wandschichten des mehrwandigen Rohres (1) - insbesondere des doppelwandigen Rohres (1) - durch Erhitzen miteinander verlötet bzw. miteinander verbunden werden.

15. Mehrwandiges Rohr - insbesondere hergestellt mit einem Verfahren nach einem der Ansprüche 1 bis 14 - mit einem aufgerollten Metallband (2), wobei das Metallband (2) zumindest eine Stahlschicht (3) und zumindest eine auf die Stahlschicht (3) mittels Plasmabeschichtung aufgebrachte Lotschicht (4) aufweist.
